(19) Europäisches Patentamt
European Patent Office
Office européen des brevets

(11) EP 0 289 032 B1

(12) EUROPEAN PATENT SPECIFICATION

(45) Date of publication and mention of the grant of the patent:
**08.01.1997 Bulletin 1997/02**

(51) Int Cl.[6]: **H03B 9/10**, H05B 6/66, H02M 3/335

(21) Application number: **88106860.5**

(22) Date of filing: **29.04.1988**

# (54) Magnetron feeding apparatus and method of controlling the same

Magnetronversorgungseinrichtung und Steuerverfahren

Dispositif d'alimentation pour magnétron et méthode de commande

(84) Designated Contracting States:
**DE FR GB IT NL SE**

(30) Priority: **30.04.1987 JP 106636/87**
**14.05.1987 JP 117339/87**
**14.05.1987 JP 117344/87**

(43) Date of publication of application:
**02.11.1988 Bulletin 1988/44**

(73) Proprietor: **MATSUSHITA ELECTRIC INDUSTRIAL CO., LTD.**
**Kadoma-shi, Osaka-fu, 571 (JP)**

(72) Inventors:
- **Suenaga, Haruo**
  **Soraku-gun Kyoto-fu (JP)**
- **Maehara, Naoyoshi**
  **Shiki-gun Nara-ken (JP)**
- **Sakamoto, Kazuho**
  **Soraku-gun Kyoto-fu (JP)**
- **Matsumoto Takahiro**
  **Ikoma-gun Nara-ken (JP)**
- **Niwa, Takashi**
  **Ikoma-gun Nara-ken (JP)**
- **Bessho, Daisuke**
  **Yamatokoriyama-shi Nara-ken (JP)**

(74) Representative: **Eisenführ, Speiser & Partner**
**Martinistrasse 24**
**28195 Bremen (DE)**

(56) References cited:
**FR-A- 2 284 976**
**FR-A- 2 324 116**
**US-A- 4 318 165**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 289 032 B1

## Description

The invention relates to a magnetron feeding apparatus comprising a DC power supply, an inverter circuit for converting DC current into high-frequency power through the switching operation of a semiconductor switch, a high-tension transformer which converts the high-frequency power into high-tension power to be applied from a high-tension winding to a magnetron, whereas the filament of the magnetron is heated by a low-tension heating winding of the high-tension transformer, an output voltage detector for detecting the output voltage of the high-tension winding of the high-tension transformer, a current detector for detecting the input current into the inverter circuit, and a power controlling means having an error amplifier means for deriving a control value from the output voltage information signal of the output voltage detector and the current information signal of the current detector for controlling the switching operation of the semiconductor switch. The invention also relates to a method of controlling a magnetron feeding apparatus using a software processing portion.

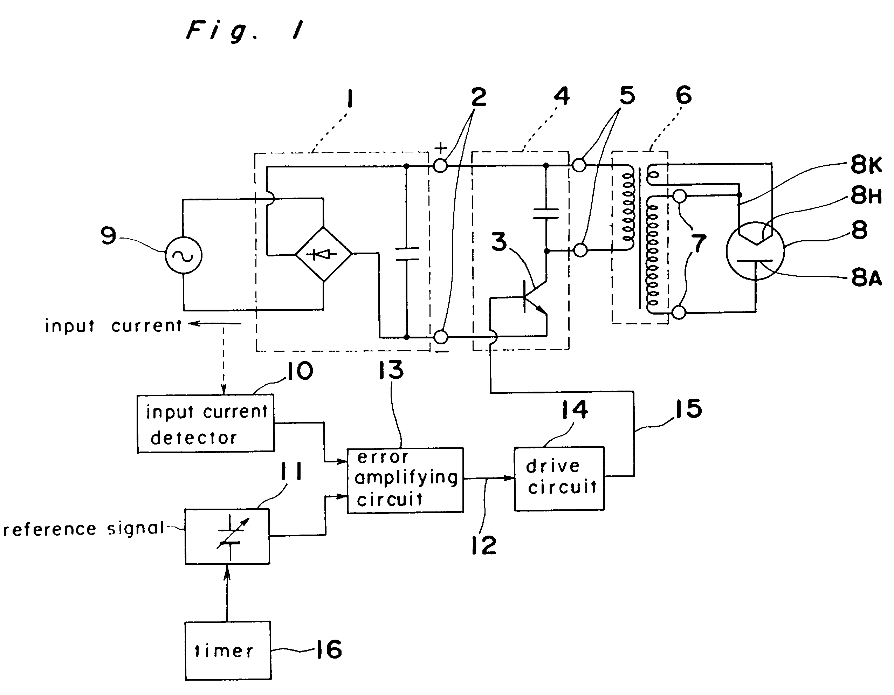

Generally, a magnetron feeding apparatus shown in Fig. 1 is adapted to convert DC power 2 from a power supply portion 1 into high-frequency power 5 by an inverter circuit 4 using a semiconductor switch 3 such as a transistor, and furthermore to convert it into high-tension power 7 by a high-tension transformer 6 to feed the power to a magnetron 8.

Also, a method of controlling the feeding power comprises steps of detecting the input current from a commercial power supply 9 by an input detecting portion 10, forming the difference information 12 between its value and the reference signal 11 by an error amplification circuit 13, a driving circuit 14 generates the driving pulse 15 corresponding to the difference information 12 to turn on, off the semiconductor switch 3, so that the input current is controlled to become a given value.

However, as most of the power to be fed to the magnetron 8 is consumed only by a heater $8_H$ before the magnetron 8 starts its oscillation, the power feeding operation will be approximately one-seventh of feed power at the steady-state time when the magnetron 8 is oscillating.

Namely, if the input current is controlled to the given value in a period before the magnetron 8 starts its oscillation, the excessive power is applied on the heater $8_H$ and also the excessive voltage is applied upon between the anode $8_A$ and the cathode $8_K$, thus resulting in the life service of the magnetron 8 being shorter because of discharging, deteriorated insulation or the like.

The reference signal 11 is set to a value smaller at the steady-state time before the magnetron 8 starts its oscillation so as to be controlled to small input current which is proper to the heater heating operation. By the use of a timer 16, the reference signal 11 is switched to the value at the steady-state time after the lapse of the time sufficient enough for the magnetron 8 to start its oscillation, so that the input current may be controlled to a value at the steady-state time.

As time required for the oscillation to be started is two seconds when the magnetron 8 is kept warm, four seconds when it is kept cold, the time for the timer 16 is set as five seconds for safety.

In such a case the magnetron 8 does not produce a wave output for five seconds, so that three seconds of time are lost when the magnetron was warm. In case the magnetron 8 was cold only one second is wasted. Accordingly, the heating operation of such an electronic range is delayed.

From US-A-4,318,165 a magnetron feeding apparatus is known comprising an inverter circuit and a high-tension transformer for converting high-frequency power into high-tension power to be applied to a magnetron. The apparatus includes an output voltage detector, a current detector and a power controlling means for controlling the switching operation of a semiconductor switch of the inverter circuit. The current detector is provided to detect the peak current in the transistor of the inverter for the purpose of limiting it to a safe value. Before the magnetron starts its oscillation, a filament control circuit provides a lower output voltage of the inverter circuit in order not to overload the filament of the magnetron and to avoid excessive high voltages.

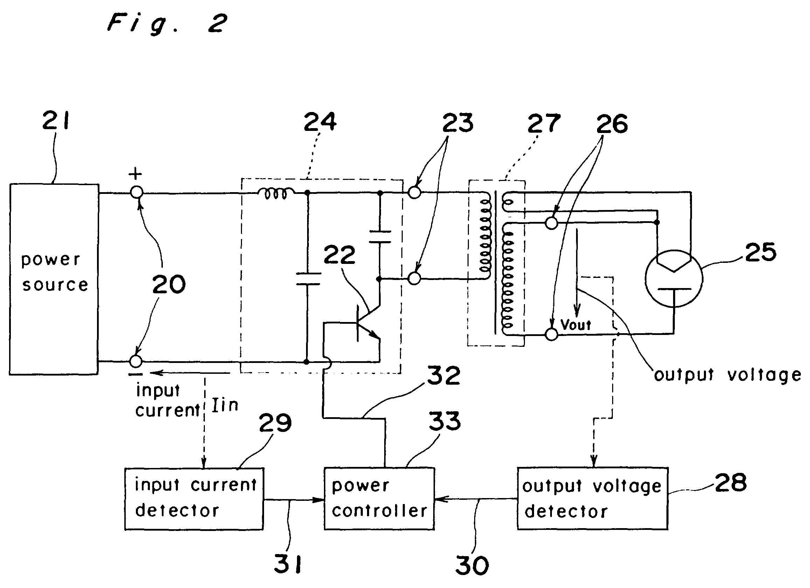

A similar magnetron feeding apparatus without such a filament control circuit is shown in figure 2 of the drawings , which includes a power supply portion 21 for feeding DC current 20, an inverter circuit 24 which switches in high frequency the DC power supply 20 by a semiconductor switch 22 to convert it into high-frequency power 23, a high-tension transformer 27 which converts the high-frequency power 23 into the high-tension power 26 necessary for the operation of a magnetron 25, an output voltage detecting portion 28 which detects the output voltage $V_{OUT}$ of the high-tension transformer 27, an input current detecting portion 29 which detects the input current $I_{IN}$ into the inverter circuit 24, a power control portion 33 for controlling the switching operation of an inverter circuit 24 through the outputting of driving pulses 32 which turn on, off the semiconductor switch 22 by the use of the output voltage information 30 of the output voltage detecting portion 28 and the input current information 31 of the input current detecting portion 29.

It is an object of the present invention to provide a magnetron feeding apparatus which is capable of controlling the output voltage of the high tension transformer and the input current to the inverter in such a way that excessive voltages at the magnetron are avoided in a period before the magnetron starts its oscillation in the warm-up period. Furthermore, the control shall be effected in such a way that no fixed warm-up time is needed, i.e. the oscillation condition of the magnetron is reached within the shortest time, independently whether the apparatus is switched on in a cold or warm condition of the magnetron.

According to the invention, a magnetron feeding apparatus of the kind as described in the preamble of claim 1 is characterized in that the power controlling means is adapted such the switching operation of the semiconductor switch is controlled only by the larger control value derived from the output voltage information signal or an input current information signal; a comparator for comparing the voltage output information signal with a first reference signal and controlling a transistor into conductive state if the voltage output information signal is larger than the first reference signal; a second error amplifier for comparing the current input information signal with a second reference signal to provide an output signal for controlling the switching operation of the semiconductor switch; the output of the transistor being connected to the second reference signal for short-circuiting it in its conductive state; and a further comparator comparing the output voltage information signal with a further reference signal, the further comparator enabling gradual increasing means if the output voltage information is smaller than the further reference signal.

Preferable embodiments are defined in the dependent claims. Moreover, a method of controlling a magnetron feeding apparatus using software control in connection with a microcomputer is defined in claim 5.

By the arrangement of the present invention as described above, an improved magnetron feeding apparatus removes the above-described wasteful time without lowering the service life of the magnetron.

These and other objects and features of the present invention will become clear from the following description taken in conjunction with the preferred embodiments thereof with reference to the accompanying drawings, in which:

Fig. 1 is a block diagram of a conventional magnetron feeding apparatus;
Fig. 2 is a block diagram of another conventional magnetron feeding apparatus;
Fig. 3 is a block diagram in a first embodiment of a power controlling portion;
Fig. 4 shows a start characteristic graph of a magnetron feeding apparatus;
Fig. 5 is a block diagram in the other embodiment of a first reference signal generating circuit;
Fig. 6 is a block diagram of a first gradual increasing circuit;
Fig. 7 is a block diagram in the other embodiment of a power controlling portion which is partially changed in Fig. 4;
Fig. 8 is a characteristic graph thereof;
Fig. 9 is a block diagram in a second embodiment of a power controlling portion;
Fig. 10 is a block diagram in a third embodiment of a power controlling portion;
Fig. 11 is a characteristic graph of a magnetron feeding apparatus in this case;
Fig. 12 is a circuit block diagram of a magnetron feeding apparatus when the power controlling operation is performed by the software processing operation;
Fig. 13 is a conceptional diagram of a program flow of a software processing portion;
Fig. 14 is a flow chart in a first embodiment of a software processing portion;
Fig. 15 is a flow chart in a second embodiment of a software processing portion; and
Fig. 16 is a flow chart in a third embodiment of a software processing portion.

Before the description of the present invention proceeds, it is to be noted that like parts are designated by like reference numerals throughout the accompanying drawings.

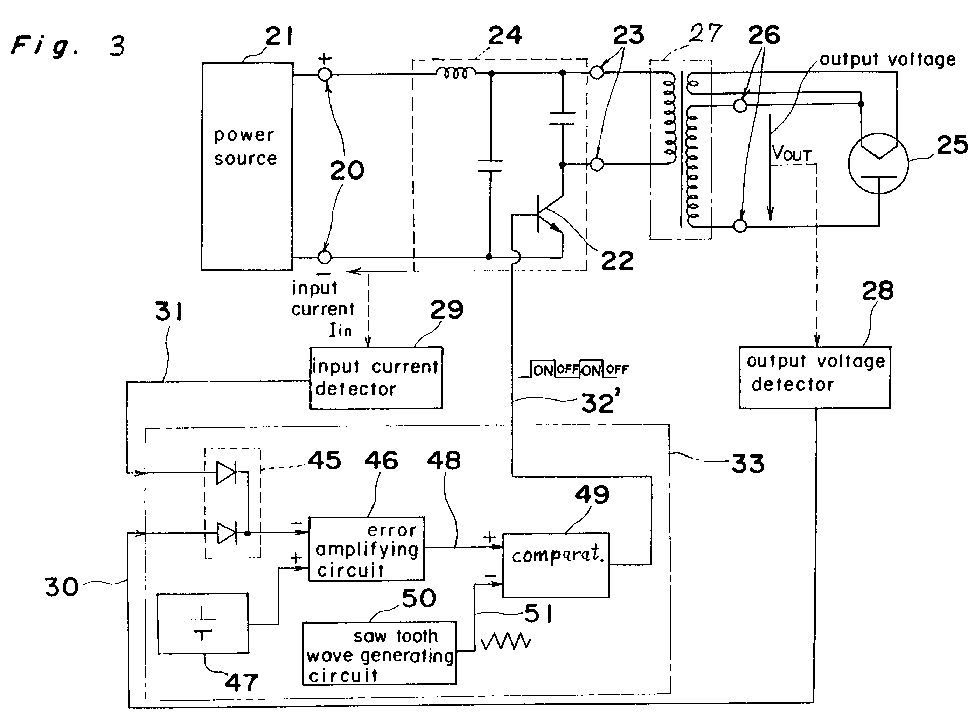

Fig. 3 is a block diagram showing the first embodiment of a power control portion 33. A diode circuit 45 inputs the larger information of the output voltage information 30 and the input current information 31 into a first error amplification circuit 46.

An error amplification circuit 46 outputs a difference signal 48 between this input and the output of a reference signal generating circuit 47. A comparator 49 outputs a driving pulse 32' which turns on, off the semiconductor switch 22 by the difference signal 48 and a saw-tooth wave 51 from a saw-tooth wave generating circuit 50 through a comparator 49.

Also, the constant of each portion is set so that the input voltage information 30 in the output voltage : $V_{OUT}=7_{KVo\text{-}p}$ may conform to the output of the reference signal generating circuit 47, and the input current information 31 in the input current : $L_{IN}=12_A$ may conform to the output of the reference signal generating circuit 47.

In a period before the magnetron 25 starts its oscillation by such construction as described hereinabove, the condition of the input current $L_{IN}=2_A$ is established with respect to the output voltage $V_{OUT}=7_{KVo\text{-}p}$. As the output voltage information 30 increased with decreases in the output of the error amplification circuit 46, so that the on time of the driving pulse 32' decreases to lower the output voltage $V_{OUT}$. Inversely, when the output voltage information 30 decreases, the on time of the driving pulse 32' increases to make the output voltage $V_{OUT}$ higher in a direction.

Also, in a condition where the magnetron 25 is oscillated, the condition of the output voltage $V_{AK}=4_{KVo\text{-}p}$ is established with respect to the input current $L_{IN}=12_A$. With increase in the input current information 31, the output in the error amplification circuit 46 is reduced to decrease the on time of the driving pulse 32', so that the operation is effected in such a direction as to reduce the input current $I_{IN}$. Inversely, when the input current 31 is reduced, the on time of the driving pulse 32' is increased, so that the operation is effected in such a way as to increase the input current $I_{IN}$.

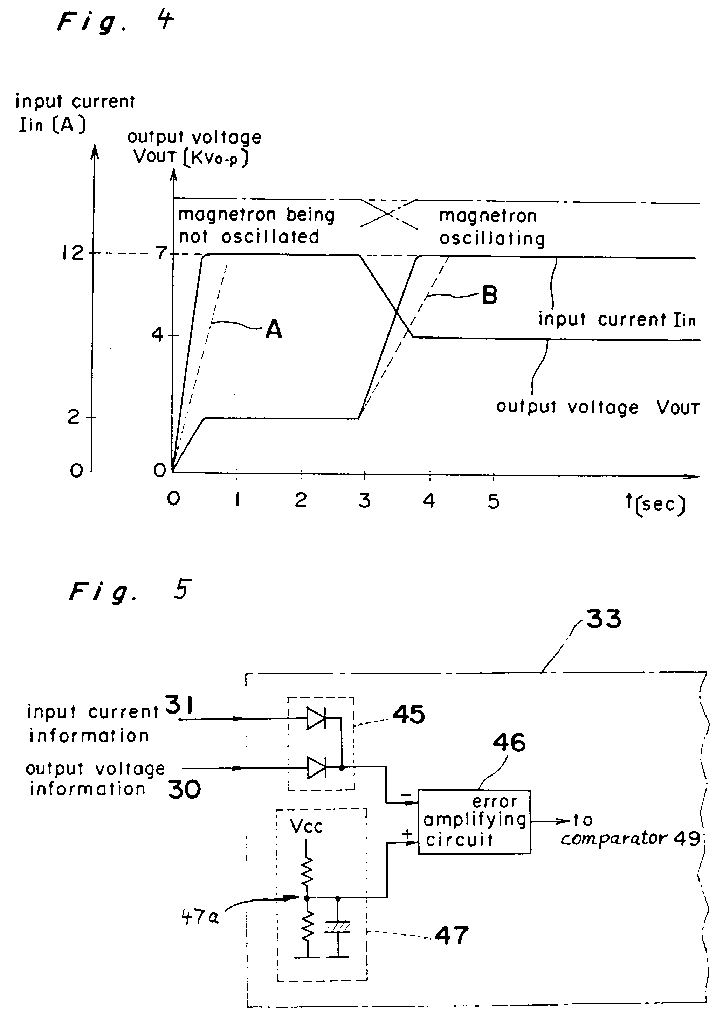

Fig. 4 is a starting characteristic graph of a magnetron feeding apparatus in such a controlled condition as described, wherein the output voltage $V_{OUT}$ is controlled to $7_{KV}$ or lower and the input current $I_{IN}$ is controlled to $12_A$. Also, upon oscillation of the magnetron 25, the starting is immediately effected up to the steady state of the input current $I_{IN}=12_A$ without the consumption of the time.

Also, in Fig. 3, such time constant circuit 47a as shown in Fig. 5 is used for the reference signal generating circuit 47, with the output voltage $V_{OUT}$ may be gradually increased up to $7_{KV}$ as shown in the dotted line A of Fig. 4.

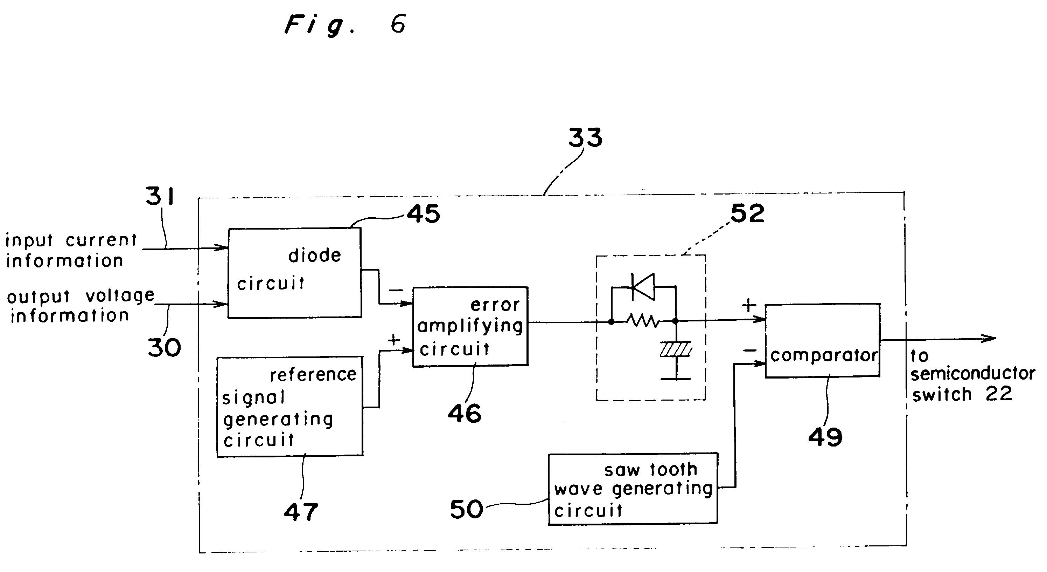

Also, in Fig. 3, by insertion of a gradual increasing circuit 52 as shown in Fig. 6 between the error amplification circuit 46 and the comparator 49, the output voltage $V_{OUT}$ and the input current $I_{IN}$ may be gradually increased as shown in the dotted line A and the dotted line B of Fig. 4.

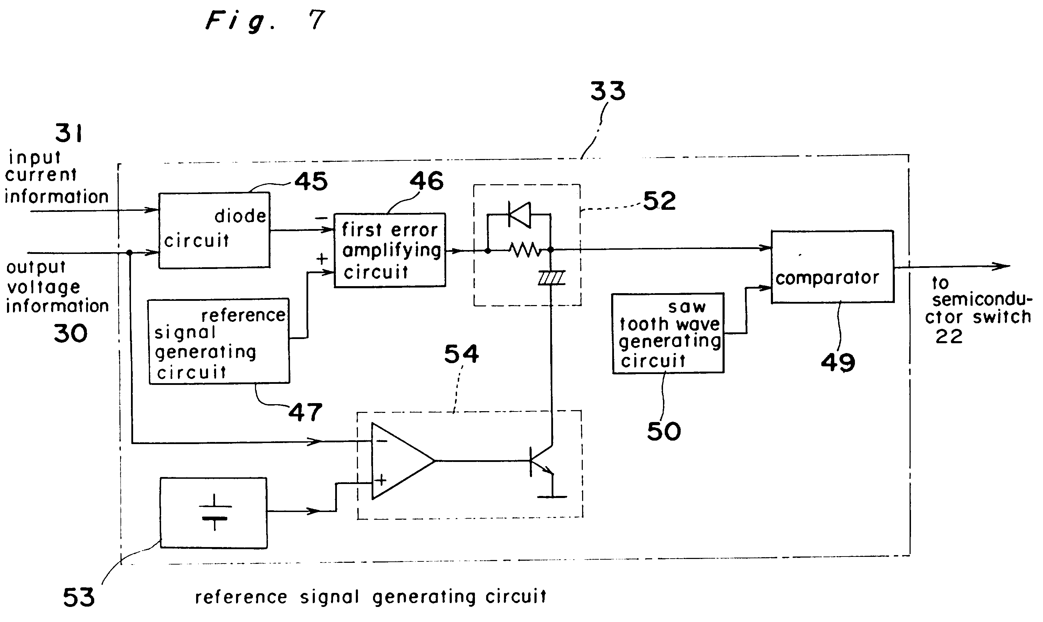

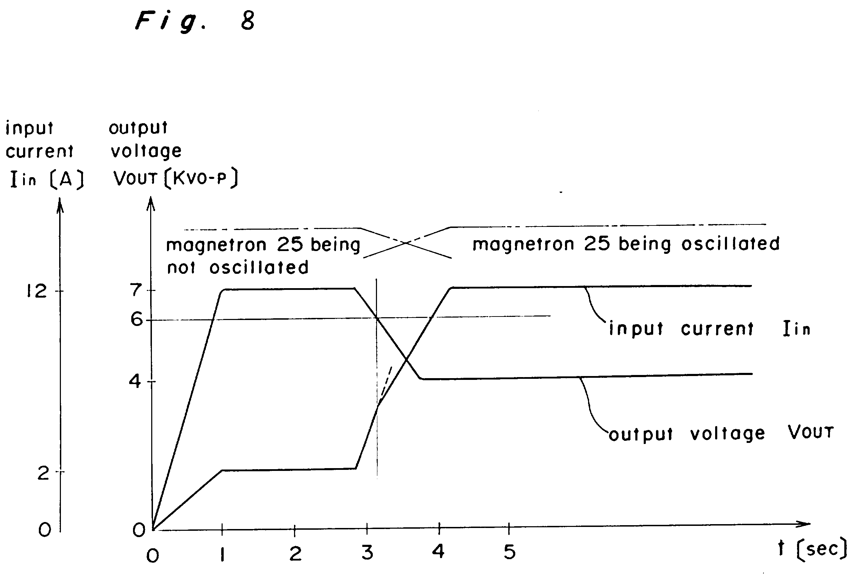

As shown in Fig. 7, by the use of the gradual increasing circuit 52, an additional reference signal generating circuit 53 equivalent to, for example $6_{KVo\text{-}p}$ in the output voltage $V_{OUT}$ is $6_{KVo\text{-}p}$ or more, and it is turned on when the output voltage $V_{OUT}$ is $6_{KVo\text{-}p}$ or lower, so that the input current $I_{IN}$ may be gradually increased in the output voltage $V_{OUT}<6_{KVo\text{-}p}$ as shown in Fig. 8.

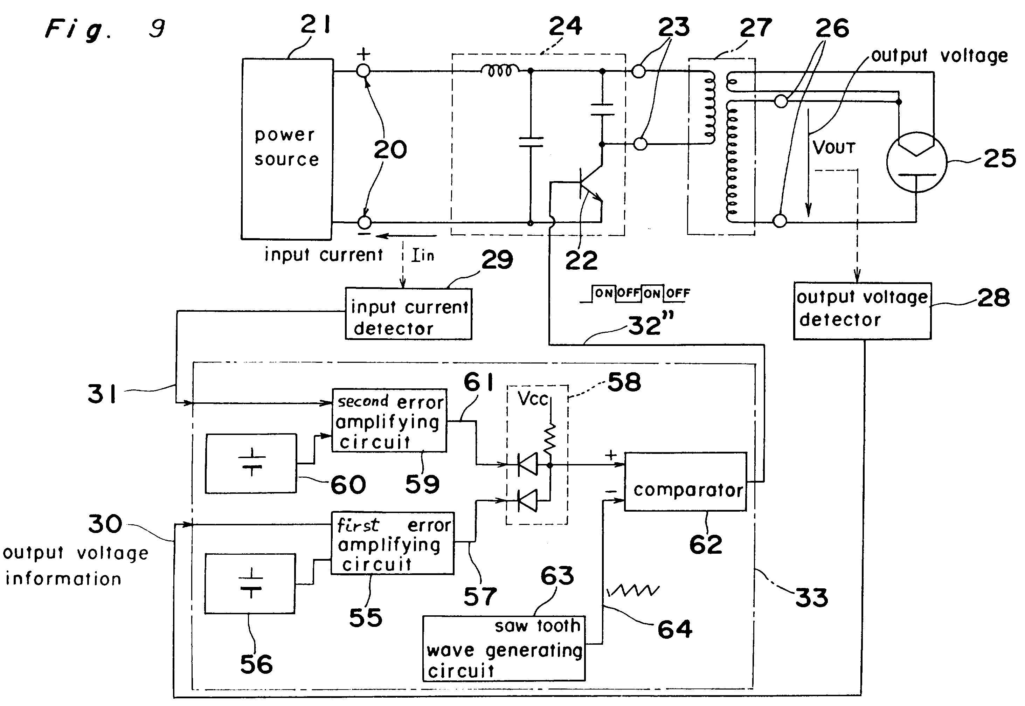

Fig. 9 is a block diagram showing a second embodiment of a power control portion.

A first error amplification circuit 55 outputs a difference signal 57 between the output voltage information 30 and the reference signal of a reference signal generating circuit 56 to a diode circuit 58.

Similarly, a second error amplification circuit 59 outputs a difference signal 61 between the input current information 31 and the reference signal of a reference signal generating circuit 60 to the diode circuit 58. The diode 58 outputs to a comparator 62 the smaller one of two difference signals 57, 61. The comparator 62 outputs a driving pulse 32" which turns on, off the semiconductor switch 22 by the input and the sawtooth wave 64 from a sawtooth wave generating circuit 63.

The constant of each portion is set so that the output voltage information 30 in the output voltage $V_{OUT}=7_{KVo\text{-}p}$ conforms to the output of the reference signal generating circuit 56, and the input current information 31 in the input current $I_{IN}=12_A$ conforms to the output of the reference signal generating circuit 60.

In such a period before the magnetron 25 starts its oscillation by such construction as described hereinabove, the required input current $I_{IN}$ when the output voltage $V_{OUT}$ is $7_{KVo\text{-}p}$ as shown in Fig. 4 or 8 is approximately $2_A$, so that the difference signal 61 from the second error amplification circuit 59 becomes larger than the difference signal 57 from the first error amplification circuit 55.

Accordingly, in this period, the required input current $I_{IN}$ less, i.e., the difference signal 57 from the first error amplification circuit 55 is selectively outputted by the diode circuit 58. Thus, with increase in the output voltage information 30, the output of the first error amplification circuit 55 is decreased to reduce the on time of the driving pulse 32", so that the operation is effected in such a direction as to decrease the output voltage $V_{OUT}$. Inversely, when the output voltage information 30 is reduced, the on time of the driving pulse 32" increases so that the operation takes place in such a direction as to increase the output voltage $V_{OUT}$.

Also, in a condition where the magnetron 25 is oscillated, the output voltage $V_{OUT}$ when the input current $I_{IN}$ is approximately 4A as shown in Fig. 4 or 8, so that the difference signal 57 from the first error amplification circuit 55 becomes larger than the difference signal 61 from the second error amplification circuit 59.

Accordingly, in this period, the required input current $I_{IN}$ small, i.e., the difference signal from the second error amplification circuit 59 is selectively outputted by the diode circuit 58. Thus, with increase in input current information 31, the output of the second error amplification 59 decreases to reduce the on time of the driving pulse 32", so that the operation is effected in such a direction as to reduce the input current $I_{IN}$. Inversely, the input current information 31 decreases, so that the operation is effected in such a way as to increase to make the input current $I_{IN}$ more through the increase of the on time of the driving pulse 32".

Even in the second embodiment, the starting characteristics becomes the same as those of the starting characteristics graph of the first embodiment shown in Fig. 4.

Also, the reference signal generating circuit 56 is constructed to have the time constant of the above-described Fig. 5, so that the controlling operation may be performed so as to gradually increase the output voltage $V_{OUT}$ as far as $7_{KV}$ as shown in the dotted line A of Fig. 4.

Similarly, the gradual increasing circuit 52 shown in Fig. 6 is inserted between the diode circuit 58 and the comparator 62, so that the controlling operation may be controlled so as to gradually increase the output voltage $V_{OUT}$ and the input current $I_{IN}$ as in the dotted line A of Fig. 4 and the dotted line thereof. The gradual increasing circuit 52 is turned on and off in accordance with the output voltage information 30 as shown in Fig. 7 to gradually increase the input current $I_{IN}$.

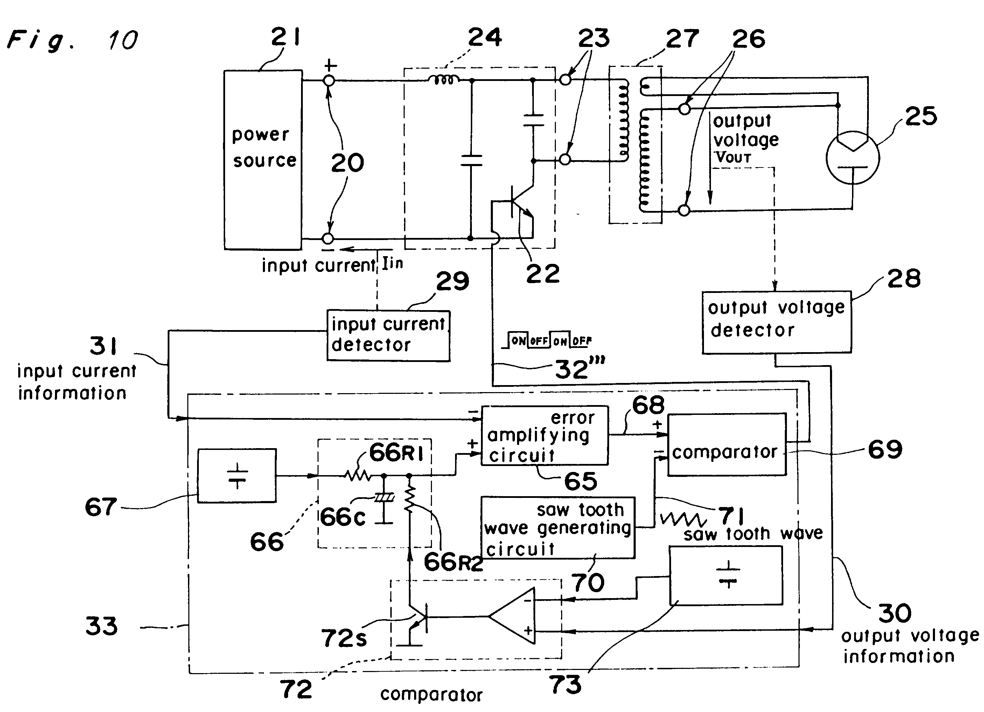

Fig. 10 is a block diagram showing the third embodiment of the power control portion 33. Referring to Fig. 10, an error amplification circuit 65 outputs to a comparator 69 the difference signal 68 between the reference signal from a reference signal generating circuit 67 passing through a gradual increasing, gradual decreasing circuit 66, and the input current information 31. The comparator 69 outputs a driving pulse 32" which switches on, off the semiconductor switch 22 through the difference signal 68 and a sawtooth wave 71 from a sawtooth wave generating circuit 70.

Also, the constant of each portion is set so that the input current information 31 in the input current $I_{IN}=12_A$ may conform to the output of the reference signal generating circuit 67.

Also, a further comparator 72 compares the output voltage information 30 with the output from the reference signal generating circuit 73 corresponding to the output voltage information 30 in the output voltage $V_{OUT}=7_{KVo\text{-}p}$ to turn off a switch 72s when the output voltage $V_{OUT}$ is smaller than $7_{KVo\text{-}p}$ so as to charge a capacitor 66c through a resistor $66_{R1}$ up to the output value of the reference signal generating circuit 67. Also, when the output voltage $V_{OUT}$ becomes larger than $7_{KVo\text{-}p}$, the switch 72s is turned on to discharge the capacitor 66c through a resistor 66Rz by a short time constant with respect to the changing.

When the output voltage $V_{OUT}$ becomes larger than $7_{KVo\text{-}p}$ through the above-described construction in a period before the magnetron 25 starts its oscillation, the normal input of the error amplifying circuit 65 is decreased, and the output of the difference signal 68 from the fourth error amplifying circuit 65 is decreased to reduce the on time of the driving pulse 32", so that the input current $I_{IN}$ decreases to lower the output voltage $V_{OUT}$.

Inversely, when the output voltage $V_{OUT}$ becomes smaller than $7_{KVo\text{-}p}$, the on time of the driving pulse 32" is increased, so that the operation is effected in a direction of increasing the output voltage $V_{OUT}$.

Also, in a condition where the magnetron 25 is oscillated, the output voltage $V_{OUT}$ is approximately $4_{KVo\text{-}p}$, with the switch 72s being off.

Accordingly, the input current information 31 increases, the output of the fourth error amplification circuit 65 is decreased to reduce the on time of the driving pulse 32" so that the operation is effected in such a direction as to reduce the input current $I_{IN}$. Inversely, when the input current information 31 is decreased, the on time of the driving pulse 32" is decreased so that an operation is effected in such a way as to increase the input current $I_{IN}$.

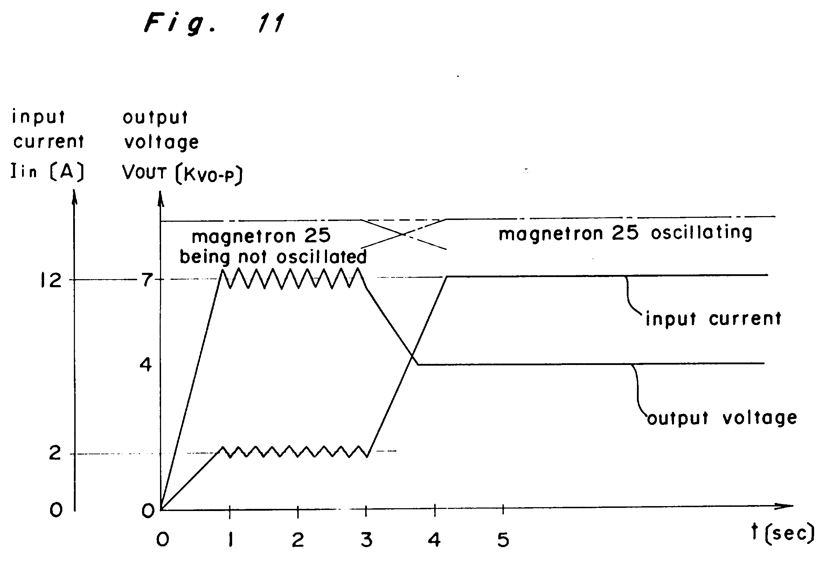

Fig. 11 is a characteristic graph of a magnetron feeding apparatus in such a condition as described hereinabove.

As shown in Fig. 11, in a period before the magnetron 25 starts its oscillation, the output voltage $V_{OUT}$ increases up to $7_{KVo\text{-}p}$, thereafter minutely vibrates around $7_{KVo\text{-}p}$ and the input current $I_{IN}$ increases up to $12_A$ and then is controlled constant.

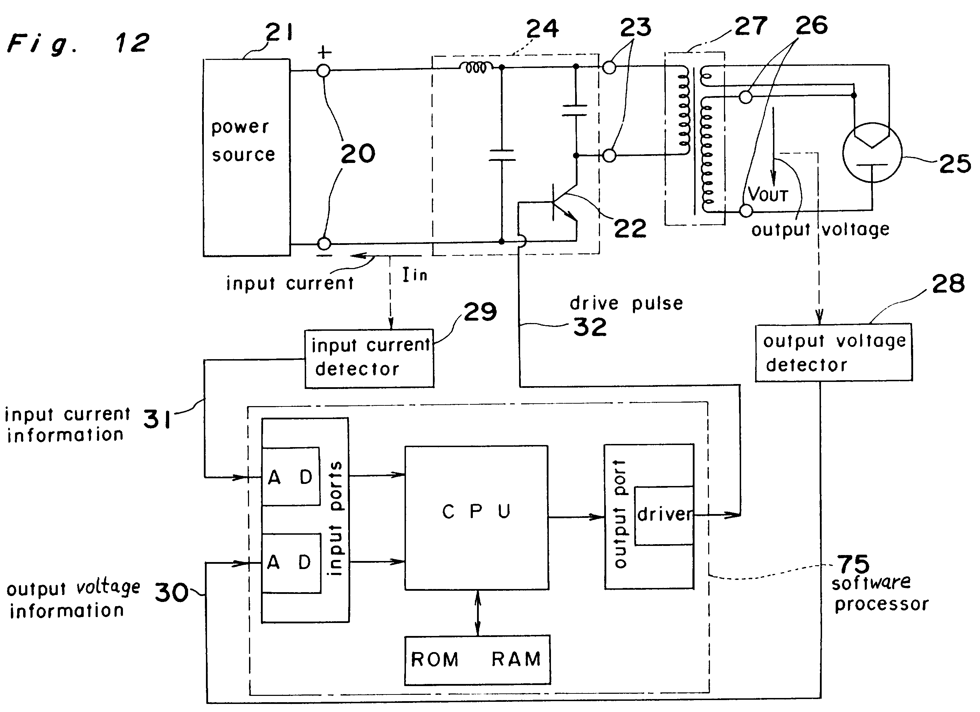

Fig. 12 is a circuit block diagram in a case where the power control of the magnetron feeding apparatus is effected by software processing.

Referring to Fig. 12, a software processing portion 75 inputs the input current information 31 from the input current detecting portion 29 and the output voltage information 30 from the output voltage detecting portion 28 to change the on time of the driving pulse 32 which turns on, off the semiconductor switch 22 in accordance with the value of two information 31, 30 to perform the power control of the magnetron feeding apparatus.

An A/D converter, which is adapted to convert the input current information 31 and the output voltage information 30 into digital signals convenient for software processing, is used for the software processing portion 75, with the converting operation being omitted in the present application.

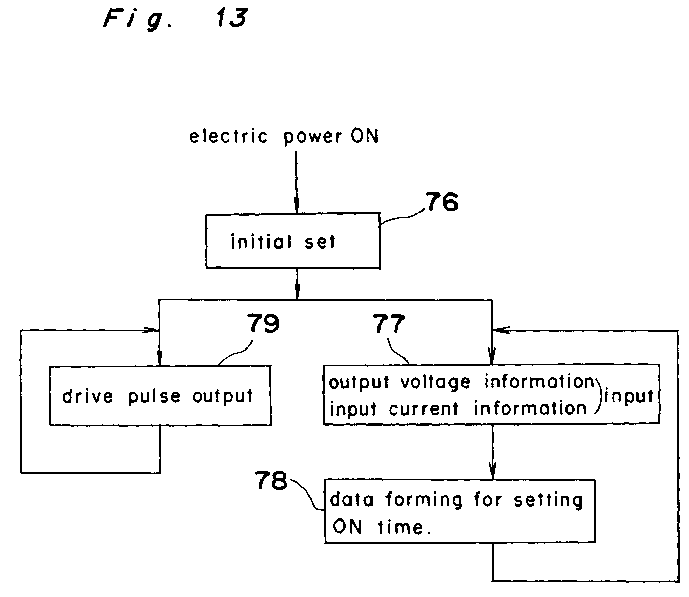

Fig. 13 is a conceptional diagram of a program flow of the software processing portion 75. Referring to Fig. 13, the power supply is turned on to perform the initial setting 76 for inner data or the like, thereafter to repeat the inputting operation 77 of the output voltage information 30 and the input current information 31, the production of the data for setting the on time to set the on time of the semiconductor switch by the use of this information the outputting operation 79 of the deriving pulse 32 for turning on, off the semiconductor switch 22 by the use of the data for setting the on time.

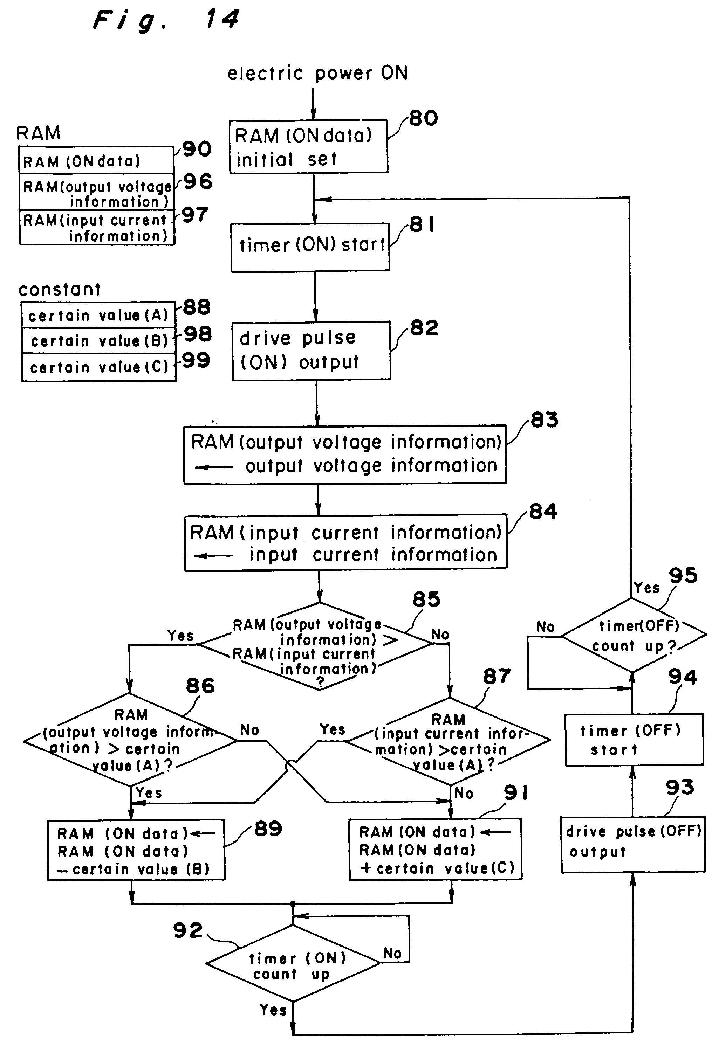

Fig. 14 is a flow chart showing the first embodiment of the software processing portion 75. Referring to Fig. 14, the RAM (on data) initial setting 80 is effected, to shorten the initial on time of the semiconductor switch 22, when the power supply is turned on. Then, the timer (on) start 81 for setting the on time of the semiconductor switch 22 is effected in accordance with the value of the RAM (on data) 90, so that the output 82 of the driving pulse (on) which turns on the semiconductor switch 22 is effected.

RAM (output voltage information) for inputting the output voltage information 30 ← the output voltage information 83 and RAM (input current information for inputting the input current information 31 ← the input current 84 are performed. The two information is compared in RAM (output voltage information) > RAM (input current information) 85. The larger information is compared with the given value (A) 88 in RAM (output voltage information) > given value (A) 86 or RAM (input current information) > given value (A) 87. When the information is larger than the given value AA) 88, the RAM (on data) 90 is decreased by the RAM (on data) - given value (B) 89. When it is smaller than the given value (A) 88, the RAM (on data) 90 is increased by the RAM (on data) + given value (C) 91. Then, when the timer (on) completion 92 and the driving pulse (off) output 93 are performed to release the on condition of the semiconductor switch 22.

Then, after the off time of the semiconductor switch 22 has been controlled by the timer (off) start 94 and the timer (off) completion 95 to return to the timer (on) start 81.

By the processing as described hereinabove, the output voltage information 30 is larger than the input current information 31 in a period before the magnetron 25 starts its oscillation. When the RAM (output voltage information) 96 is larger than the given value (A) 88, the RAM (on data) 90 is decreased to make the on time of the semiconductor switch 22 shorter to reduce the output voltage $V_{OUT}$. Inversely, when the RAM (output voltage information) 96 is smaller than the given value (A) 88, the RAM (on data) 90 is increased to make the output voltage $V_{OUT}$ more.

After the magnetron 25 starts its oscillation, the input current information 31 becomes larger than the output voltage information 30. The RAM (input current information) 87 is compared with the given value (A) 88 to increase or decrease the RAM (on data) 90 in accordance with the result so that an operation is effected so as to control the input current $I_{IN}$.

The large information of the output voltage information 30 and the input current information 31 is controlled to conform to the given value (A) 88. Also, the value size of the given value (B) 98 and the given value (C) 99 may vary the change speed of the increase, decrease of the output voltage $V_{OUT}$, the input current $I_{IN}$.

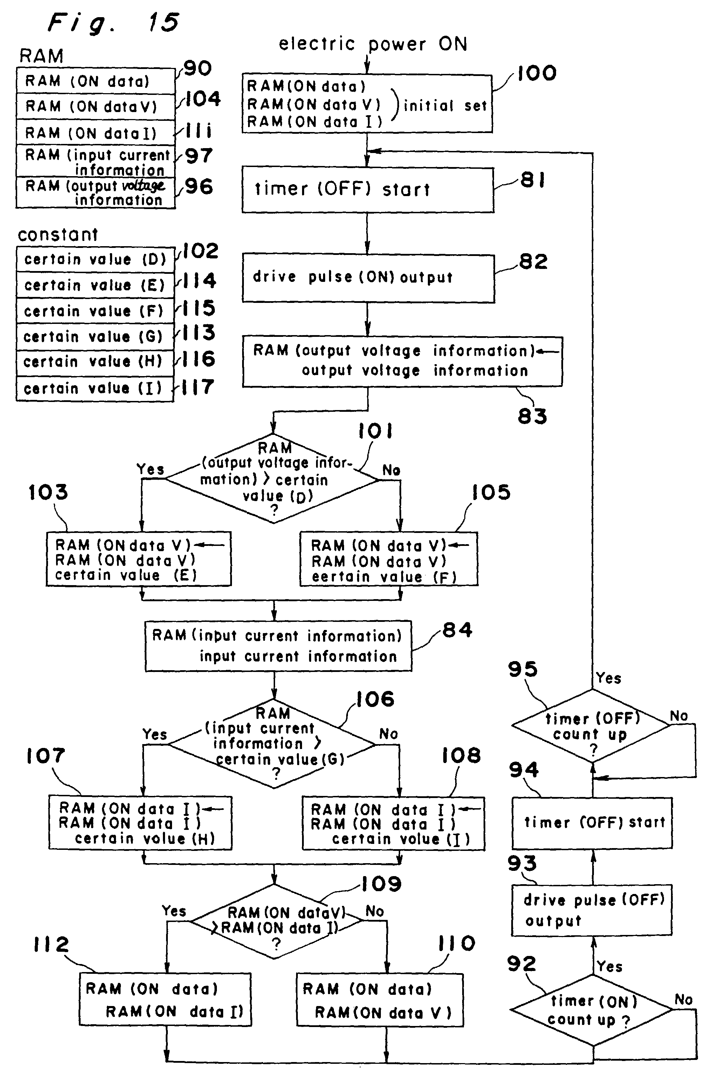

Fig. 15 is a flow chart showing the second embodiment of the software processing portion 75. Referring to Fig. 15, when the power supply is turned on, the initial setting 100 of the RAM (on data), RAM (on data V), RAM (on data I) is performed so as to shorten the initial on time of the semiconductor switch 22. Then, the timer (on ) start 81 is effected to set the on time of the semiconductor switch 22 in accordance with the value of the RAM (on data) 90, so that the (on) output 82 of the driving pulse (on) which turns on the semiconductor switch 22 is effected.

The RAM (output voltage information) for inputting the output voltage information 30 ← the output voltage information 83 is effected. The information is compared in RAM (output voltage information) > given value (D) 101. When it is larger than the given value (D) 102, the RAM (on data V) 104 is reduced in RAM (on data V) - given value (E) 103. When it is smaller than the given value (D) 102, the RAM (on data V) 104 is increased in RAM (on data V) + given value (F) 105.

Then, similarly, RAM (input current information) ← input current information 84, RAM (input current information) > given value (G) 106, and RAM (on data I) - given value (H) 107 or RAM (on data I) + given value (I) 108 are effected.

Then, a comparing operation is performed in RAM (on data V) > RAM (on data I) 109. When RAM (on data V) 104 is smaller, RAM (on data) ← RAM (on data V) 110 is effected. When RAM (on data I) 111 is smaller, RAM (on data) ← RAM (on data I) 112 is effected.

Then, the timer (on) completion 92 and the driving pulse (off) output 83 are effected to release the on condition of the semiconductor switch 22.

Then, the off time of the semiconductor switch 22 is controlled by the timer (off) start 94 and the timer (off) completion 95 and thereafter it returns to the timer (on) start 81.

By such processing as described, the RAM (output voltage information) 96 approaches the given value (D) 102 in a period before the magnetron 25 starts its oscillation. Also, RAM (input current information) 97 << given value (G) 113, thus resulting in RAM (on data V) 104 < RAM (on data I) 111, with RAM (on data) 90 conforming in value to the RAM (on data V) 104.

Accordingly, in this period, when RAM (output voltage information) 96 is larger than the given value (D) 102, the RAM (on data V) 104 is decreased to make the on time of the semiconductor switch 22 shorter so as to reduce the output voltage $V_{OUT}$. Inversely, when it is smaller, the RAM (on data V) 104 is increased to make the output voltage $V_{OUT}$ higher, so that the output voltage information 30 is controlled to conform to the given value (D) 102.

Also, after the magnetron 25 has started its oscillation, the RAM (input current information) 97 is approached to the given value 113, RAM (output voltage information 96 << given value (D)) 102, thus resulting in RAM (on data V) 104 > RAM (on data I) 111, with RAM (on data) 90 conforming to the RAM (on data I) 111.

Accordingly, in this period, the RAM (on data I) 111 is decreased when the RAM (input current information) 97 is larger than the given value (G) 113 to make the on time of the semiconductor switch 22 shorter so as to decrease the input current $I_{IN}$. Inversely, when it is smaller, RAM (on data I) 111 is increased to increase the input current $I_{IN}$, so that the input current information 31 is controlled to conform to the given value (G) 113. The processing that the value of the RAM (on data) 90 is set though the choice of the smaller of the RAM (on data V) 104 and the RAM (on data I) 111 results in the choice of the smaller one of the required input current $I_{IN}$. Also, the change speed of increase, decrease in the output voltage $V_{OUT}$ may be varied by the given value (E) and the given value (F) 115, while the change speed of increase, decrease in the input current $I_{IN}$ may be varied by the given value (H) 116 and the given value (I) 117.

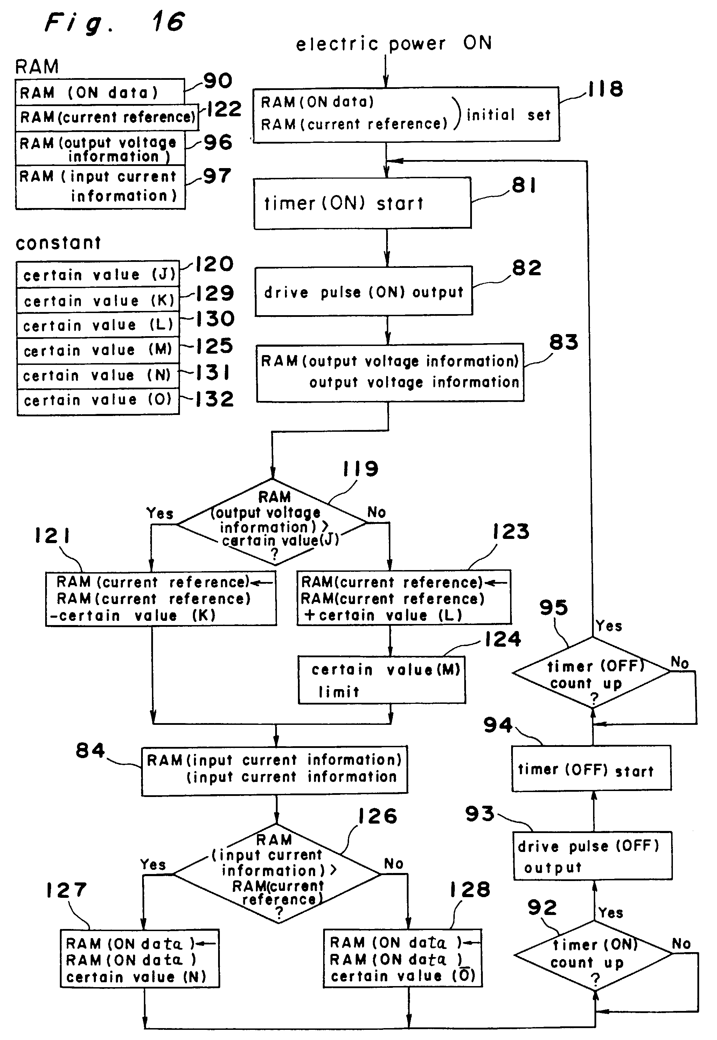

Fig. 16 is a flow chart showing the third embodiment of a software processing portion 75. Referring to Fig. 16, when the power supply is turned on, the initial setting 118 of the RAM (on data), RAM (current reference) is effected to shorten the first on time of the semiconductor switch 22. Then, the timer (on) start 81 is effected which sets the on time of the semiconductor switch 22 by the use of the RAM (on data) 90 to perform the outputting operation 82 of the driving pulse (on) which turns on the semiconductor switch 22.

The RAM (output voltage information) for inputting the output voltage information 30 ← the output voltage information 83 is effected.

This information is compared in RAM (output voltage information)> given value (J) 119, the RAM (current reference) 122 is decreased in RAM (current reference) - given value (K) 121. Inversely, when it is smaller than the given value (J) 120, the RAM (current reference) 122 is increased in (RAM current reference) + given value (L) 123. The maximum value of the RAM (current reference) 122 in this case is restricted to the given value (M) limit 124 of the RAM (current reference) 122.

Then, RAM (input current information) for inputting the current information 31 ← the input current information 84 is effected.

This information is compared with the RAM (input current information) > RAM (current reference) 126. When it is larger than the RAM (current reference) 122, the RAM (on data) 90 is decreased in the RAM (on data) - given value (N) 127. Inversely, when it is smaller, the RAM (on data) 90 is increased in RAM (on data) + given value (ō) 128.

Then, the timer (on) completion 92 and the driving pulse (off) output 93 are effected to release the on condition of the semiconductor switch 22.

Then, after the off time of the semiconductor switch 22 has been controlled by the timer (off) start 94 and the timer (off) completion 95, it is returned to the timer (on) start 81.

By such processing as described hereinabove, the RAM (output voltage information) 96 approaches the given value (J) 120 in a period before the magnetron 25 oscillates, with the RAM (current reference) 122 being not limited to the given value (M) 125.

When the RAM (output voltage information) 96 is larger than the given value (J) 120, the RAM (current reference) 122 is reduced, with the result that RAM (on data) 90 is reduced so that the RAM (input current information) 97 may follow the reduced RAM (current reference) 122. Accordingly, the on time of the semiconductor switch 22 is reduced to decrease the output voltage $V_{OUT}$ and the input current $I_{IN}$. Inversely, when the RAM (output voltage information) 96 is smaller than the given value (J) 120, the RAM (on data) 90 is increased and the output voltage $V_{OUT}$ and the input current $I_{IN}$ are increased.

The RAM (output voltage information) 96 is controlled to conform to the given value (J) 120 in this period.

Also, in a period after the magnetron 25 has started its oscillation, RAM (output voltage information) 96 << given value (J) 120, with RAM (current reference) 122 becoming the same in value as the given value (M) 125.

Accordingly, when the RAM (input current information) 97 is larger than the given value (M) 125, the RAM (on data) 90 is reduced to shorten the on time of the semiconductor switch 22 to reduce the input current $I_{IN}$. Inversely, when it is smaller, the RAM (on data) 90 is increased to make the input current Iin more, so that RAM (input current information) 97 is controlled to conform to the given value (M) 125.

Also, the change speed of the increase, decease of the output voltage $V_{OUT}$ may be respectively varied by the given value (K) 129, the given value (L) 130, the given value (IV) 131, and the given value (ō) 132. Also, the change speed of the increase, decrease of the input current $I_{IN}$ is respectively varied by the given value (N) 131 and the given value (ō) 132.

In the magnetron feeding apparatus by the present invention, optimum voltage, power may be steadily fed in a period before the magnetron starts its oscillation, the possible oscillation condition of the magnetron may be reached in a short time without application of the excessive voltage.

Also, when the possible oscillation condition is reached, the condition automatically moves to the controlling operation may be effected without consumption of the wasteful time- as far as the oscillating condition of the magnetron, and also, the oscillating condition may be steadily continued.

## Claims

**1.** A magnetron feeding apparatus comprising

a DC power supply (21), an inverter circuit for converting DC current into high-frequency power through the switching operation of a semiconductor switch (22), a high-tension transformer (27) which converts the high-frequency power into high-tension power to be applied from a high-tension winding (26) to a magnetron (25), whereas the filament of the magnetron (25) is heated by a low-tension heating winding of the high-tension transformer (27);
an output voltage detector (28) for detecting the output voltage of the high-tension winding (26) of the high-tension transformer (27), a current detector (29) for detecting the input current into the inverter circuit; and
a power controlling means (33, 75) having an error amplifier for deriving a control value from the output voltage information signal (30) of the output voltage detector (28) and the current information signal (31) of the current detector (29) for controlling the switching operation of the semiconductor switch (22);

characterized by

the power controlling means (33) being adapted such that the switching operation of the semiconductor switch (22) is controlled only by the larger control value derived from the output voltage information signal (30) or an input current information signal (31); a comparator (72) for comparing the voltage output information signal (30) with a first reference signal (73) and controlling a transistor (72s) into conductive state if the voltage output information signal (30) is larger than the first reference signal (73);
a second error amplifier (65) for comparing the current input information signal (31) with a second reference signal (67) to provide an output signal (68) for controlling the switching operation of the semiconductor switch (22);
the output of the transistor (72s) being connected to the second reference signal (67) for short-circuiting it in its conductive state; and
a further comparator (54) comparing the output voltage information signal (30) with a further reference signal (53), the further comparator (54) enabling gradual increasing means (52) if the output voltage information is smaller than the further reference signal (53).

**2.** Apparatus according to claim 1, characterized in that the output voltage detector (28) and the input current detector (29) are adapted to provide an output voltage information signal (30) and input current information signal (31) of comparable signal amplitude, that these two information signals (30, 31) are fed to a selector (45) which passes only the larger one of both information signals to a common error amplifier (46) receiving a reference signal (47).

**3.** Apparatus according to claim 1, characterized by a first error amplifier (55) for comparing the voltage output information signal (30) with a first reference signal (56) and outputting a first control value (57);

a second error amplifier (59) for comparing the current input information signal (31) with a second reference signal (60) and outputting a second control value (61); and
a selector (58) connected to both error amplifiers (55, 59) and passing only the smaller one of both control values (57, 61) for controlling the switching operation of the semiconductor switch (22).

**4.** Apparatus according to any preceding claim, characterized by gradual increasing means (47a; 52; 66C, 66R1) for controlling the increase of either the reference signal(s) (47, 67) or the control value (s) in order to gradually increase the control signal for controlling the switching ooeration of the semiconductor switch (22).

**5.** A method of controlling a magnetron feeding apparatus comprising a DC power supply, an inverter circuit for converting DC current into high-frequency power through the switching operation of a semiconductor switch, a high-tension transformer which converts the high-frequency power into high-tension power to be applied from a high-tension winding to a magnetron whereas the filament of the magnetron is heated by a low-tension heating winding of the high-tension transformer, and using a software processing portion (75) for forming the driving pulses of the semiconductor switch on the basis of an output voltage information signal (30) and an input current information signal (31);
the software processing portion (75) having a programm flow comprising the steps of

a) performing initial setting of inner data after the power supply has been put into work,
b) repeating inputting operation of the output voltage information and the input current information,
c) data forming operation for setting the on time of the semiconductor switch on the basis of the two inputted information signals,
d) driving pulse outputting operation for setting the pulse width of the driving pulse which turns on, off the semiconductor switch;

characterized by the steps of

e5) inputting the output voltage information signal (30),
f5) comparing the output voltage information signal (30) with a first reference value (D) to decrease a current reference signal when it is larger than the first reference value (D) and to increase the current reference signal when it is smaller than the first reference value (D), and
g5) limiting the largest of the increased current reference signal to a second reference value (E),
h5) inputting the input current information signal (31),
i5) comparing the input current information signal (31) with the current reference signal to decrease the data for the on time setting when it is larger than the current reference signal and increase the data when it is smaller than the current reference signal.

## Patentansprüche

**1.** Magnetronversorgungseinrichtung mit

einer Gleichstromversorgung (21);
einer Wechselrichterschaltung zum Umwandeln von Gleichstrom in Hochfrequenzleistung durch den Schaltbetrieb eines Halbleiterschalters (22);
einem Hochspannungstransformator (27), der die Hochfrequenzleistung in Hochspannungsleistung umwandelt, die von einer Hochspannungswicklung (26) einem Magnetron (25) zugeführt wird, wohingegen der Heizdraht des Magnetrons (25) über eine Niederspannungheizwicklung des Hochspannungstransformators (27) beheizt wird;
einem Ausgangsspannungsdetektor (28) zum Erkennen der Ausgangsspannung der Hochspannungswicklung (26) des Hochspannungstransformators (27);
einem Stromdetektor (29) zum Erkennen des Eingangsstroms der Wechselrichterschaltung; und
einem Leistungssteuermittel (33, 75) mit einem Fehlerverstärker zum Ableiten eines Steuerwertes aus dem Ausgangsspannungsinformationssignal (30) des Ausgangsspannungsdetektor (28) und dem Strominformationssignal (31) des Stromdetektors (29) zum Steuern des Schaltbetriebes des Halbleiterschalters (22);

dadurch gekennzeichnet,

daß das Leistungssteuermittel (33) so ausgelegt ist, daß der Schaltbetrieb des Halbleiterschalters (22) nur durch den größeren Steuerwert gesteuert wird, der aus dem Ausgangsspannungsinformationssignal (30) oder dem Eingangsstrominformationssignal (31) abgeleitet wird;
daß ein Komparator (72) vorgesehen ist zum Vergleichen des Ausgangsspannungsinformationssignals (30) mit einem ersten Referenzsignal (73) und zum Steuern eines Transistors (72s) in den leitenden Zustand, wenn das Ausgangsspannungsinformationssignal (30) größer ist als das erste Referenzsignal (73);
daß ein zweiter Fehlerverstärker (65) vorgesehen ist zum Vergleichen des Eingangsstrominformationssignals (31) mit einem zweiten Referenzsignal (67) zum Erzeugen eines Ausgangsignals (68) für die Steuerung des Schaltbetriebes des Halbleiterschalters (22);
daß der Ausgang des Transistors (72s) mit dem zweiten Referenzsignal (67) verbunden ist, um dieses in seinen leitenden Zustand kurzzuschließen, und
daß ein weiterer Komparator (54) vorgesehen ist zum Vergleichen des Ausgangsspannungsinformationssignals (30) mit einem weiteren Referenzsignal (53), welcher weitere Komparator (54) einen allmählichen Anstieg bewirkende Mittel (52a) aktiviert, wenn die Ausgangsspannungsinformation kleiner ist als das weitere Referenzsignal (53).

**2.** Einrichtung nach Anspruch 1,
dadurch gekennzeichnet, daß der Ausgangsspannungsdetektor (28) und der Eingangsstromdetektor (29) so ausgelegt sind, daß sie ein Ausgangsspannungsinformationssignal (30) und ein Eingangsstrominformationssignal (31) vergleichbarer Signalamplitude liefern,
daß diese beiden Informationssignale (30, 31) einem Selektor (45) zugeführt werden, der nur das größere der beiden Informationssignale an einen gemeinsamen, ein Referenzsignal (47) empfangenden Fehlerverstärker (46) weiterleitet.

**3.** Einrichtung nach Anspruch 1,
gekennzeichnet durch einen ersten Fehlerverstärker (55) zum Vergleichen des Ausgangsspannungsinformationssignals (30) mit einem ersten Referenzsignals (56) und Ausgeben eines ersten Steuerwertes (57);

einen zweiten Fehlerverstärker (59) zum Vergleichen des Stromeingangsinformationssignals (31) mit einem zweiten Referenzsignal (60) und Ausgeben eines zweiten Steuerwertes (61), und
einen Selektor (58), der mit beiden Fehlerverstärkern (55, 59) verbunden ist und nur den kleineren der beiden Steuerwerte (57, 61) zum Steuern des Schaltbetriebes des Halbleiterschalters (22) weiterleitet.

**4.** Einrichtung nach einem der vorangehenden Ansprüche,
gekennzeichnet durch einen allmählichen Anstieg bewirkende Mittel (47a; 52a; 66C, 66R1), die den Anstieg von entweder Referenzsignal(en) (47, 67) oder Steuerwert(en) (52) so steuern, daß das den Schaltbetrieb des Halbleiterschalters (22) steuernde Steuersignal allmählich zunimmt.

**5.** Verfahren zum Steuern einer Magnetronversorgungseinrichtung mit einer Gleichstromversorgung, einer Wechselrichterschaltung zum Umwandeln von Gleichstrom in Hochfrequenzleistung mit Hilfe des Schaltbetriebes eines Halbleiterschalters;
einem Hochspannungstransformator, der die Hochfrequenzleistung in Hochspannungsleistung zum Zuführen von einer Hochspannungswicklung an ein Magnetron umwandelt, wobei der Heizdraht des Magnetrons durch eine Niederspannungheizwicklung des Hochspannungstransformators beheizt wird;
mit einem Software-Verarbeitungsabschnitt (75) zum Erzeugen der Ansteuerimpulse für den Halbleiterschalter auf der Basis eines Ausgangsspannungsinformationssignals (30) und eines Eingangsstrominformationssignals (31);
welcher Software-Verarbeitungsabschnitt (75) einen Programmablauf aufweist, der die folgenden Schritte enthält

a) Anfangseinstellung von Innendaten, nachdem die Stromzufuhr in Tätigkeit gesetzt worden ist,
b) Wiederholen der Eingabe von Ausgangsspannungsinformation und Eingangsstrominformation,
c) Datenerzeugung zum Einstellen der Einschaltzeit des Halbleiterschalters auf der Basis der beiden eingegeben Informationssignale,
d) Ansteuerimpulsausgabe zum Einstellen der Impulsbreite des Ansteuerimpulses, der den Halbleiterschalter ein- und ausschaltet;

gekennzeichnet durch die Schritte

e5) Eingeben des Ausgangsspannungsinformationssignals (30),

f5) Vergleichen des Ausgangsspannungsinformationssignals (30) mit einem ersten Referenzwert (D) zur Verringerung eines Stromreferenzsignals, wenn es größer ist als der erste Referenzwert (D), und zur Vergrößerung des Stromreferenzsignals, wenn es kleiner ist als der erste Referenzwert (D), und

g5) Begrenzen des größten der verstärkten Referenzsignale auf einen zweiten Referenzwert (E),

h5) Eingeben des Eingangsstrominformationssignals (31),

i5) Vergleichen des Eingangsstrominformationssignals (31) mit dem Stromreferenzsignal zur Verringerung der Werte für die Einschaltzeiteinstellung, wenn sie größer sind als das Stromreferenzsignal, und zum Vergrößern der Werte, wenn sie kleiner sind als das Stromreferenzsignal.

**Revendications**

**1.** Appareil d'alimentation de magnétron comprenant une alimentation (21) électrique à courant continu, un circuit inverseur pour convertir un courant continu en une puissance à haute fréquence par l'intermédiaire d'une opération de commutation d'un commutateur (22) à semi-conducteur, et un transformateur (27) à haute tension qui convertit la puissance à haute fréquence en une puissance à haute tension destinée à être appliquée par un enroulement (26) à haute tension à un magnétron (25), tandis que le filament du magnétron (25) est chauffé par un enroulement chauffant à basse tension du transformateur (27) à haute tension ; un détecteur (28) de tension de sortie pour détecter la tension de sortie de l'enroulement (26) à haute tension du transformateur (27) à haute tension, un détecteur (29) de courant pour détecter le courant d'entrée fourni au circuit inverseur ; et

des moyens (33, 75) de commande de puissance ayant un amplificateur d'erreur pour déterminer une valeur de commande à partir du signal (30) d'information de tension de sortie du détecteur (28) de tension de sortie et du signal (31) d'information de courant du détecteur (29) de courant, pour commander l'opération de commutation du commutateur (22) à semi-conducteur ;

caractérisé par :

le fait que les moyens (33) de commande de puissance sont conçus de façon que l'opération de commutation du commutateur (22) à semi-conducteur ne soit commandée que par la valeur de commande la plus grande déterminée à partir du signal (30) d'information de tension de sortie ou d'un signal (31) d'information de courant d'entrée ;

un comparateur (72) pour comparer le signal (30) d'information de tension de sortie avec un premier signal (73) de référence et pour commander un transistor (72s) afin de le faire passer à l'état conducteur si le signal (30) d'information de tension de sortie est supérieur au premier signal (73) de référence ;

un second amplificateur (65) d'erreur pour comparer le signal (31) d'information d'entrée de courant avec un second signal (67) de référence afin de fournir un signal (68) de sortie pour commander l'opération de commutation du commutateur (22) à semi-conducteur ;

la sortie du transistor (72s) étant connectée au second signal (67) de référence pour le court-circuiter dans son état conducteur ; et

un autre comparateur (54) comparant le signal (30) d'information de tension de sortie avec un autre signal (53) de référence, l'autre comparateur (54) activant des moyens (52a) d'accroissement progressif si l'information de tension de sortie est inférieure au signal (53) de référence supplémentaire.

**2.** Appareil selon la revendication 1,

caractérisé en ce que le détecteur (28) de tension de sortie et le détecteur (29) de courant d'entrée sont conçus pour fournir un signal (30) d'information de tension de sortie et un signal d'information de courant d'entrée d'amplitudes de signal comparables, et

en ce que ces deux signaux (30, 31) d'information sont fournis à un sélecteur (45) qui ne laisse passer que le plus grand des deux signaux d'information vers un amplificateur (46) d'erreur commun recevant un signal (47) de référence.

**3.** Appareil selon la revendication 1,

caractérisé par un premier amplificateur (55) d'erreur destiné à comparer le signal (30) d'information de sortie de tension avec un premier signal (56) de référence et pour fournir en sortie une première valeur (57) de commande ;

un second amplificateur (59) d'erreur destiné à comparer le signal (31) d'information d'entrée de courant avec un second signal (60) de référence et à fournir en sortie une seconde valeur (61) de commande ; et

un sélecteur (58) connecté aux deux amplificateurs (55, 59) d'erreur et ne laissant passer que la plus petite des deux valeurs (57, 61) de commande pour commander l'opération de commutation du commutateur (22) à semi-conducteur.

4. Appareil selon l'une quelconque des revendications précédentes,

caractérisé par des moyens (47a; 52a; 66C, 66R1) d'accroissement progressif pour commander l'accroissement du signal ou des signaux de référence (47, 67) ou de la valeur ou des valeurs de commande (52), afin de faire croître progressivement le signal de commande pour commander l'opération de commutation du commutateur (22) à semi-conducteur.

5. Procédé pour commander un appareil d'alimentation de magnétron comprenant une alimentation électrique à courant continu, un circuit inverseur pour convertir un courant continu en une puissance à haute fréquence au moyen de l'opération de commutation d'un commutateur à semi-conducteur, un transformateur à haute tension qui convertit la puissance à haute fréquence en une puissance à haute tension destinée à être appliquée par un enroulement à haute tension à un magnétron, tandis que le filament du magnétron est chauffé par un enroulement chauffant à basse tension du transformateur à haute tension, et l'utilisation d'une partie (75) de traitement par logiciel pour élaborer les impulsions d'attaque du commutateur à semi-conducteur sur la base d'un signal (30) d'information de tension de sortie et d'un signal (31) d'information de courant d'entrée ;

la partie (75) de traitement par logiciel ayant une séquence programmée comprenant les étapes qui consistent :

a) à effectuer une initialisation de données internes après que l'alimentation électrique a été mise en oeuvre,
b) à répéter l'opération de fourniture de l'information de tension d'entrée et de l'information de courant d'entrée,
c) à effectuer une opération d'élaboration de données pour fixer le temps de fermeture du commutateur à semi-conducteur sur la base des deux signaux d'information fournis,
d) à effectuer une opération de fourniture d'une impulsion d'attaque pour fixer la largeur d'impulsion de l'impulsion d'attaque qui ferme ou ouvre le commutateur à semi-conducteur ;

caractérisé par les étapes qui consistent :

e5) à fournir le signal (30) d'information de tension de sortie,
f5) à comparer le signal (30) d'information de tension de sortie avec une première valeur (D) de référence pour réduire un signal de référence de courant lorsqu'il est supérieur à la première valeur (D) de référence et pour faire croître le signal de référence de courant lorsqu'il est inférieur à la première valeur (D) de référence, et
g5) à limiter le plus grand des signaux de référence de courant augmenté, à une seconde valeur (E) de référence,
h5) à fournir le signal (31) d'information de courant d'entrée,
i5) à comparer le signal (31) d'information de courant d'entrée avec le signal de référence de courant pour réduire les données de fixation du temps de fermeture, lorsqu'il est supérieur au signal de référence de courant, et pour faire croître la donnée lorsqu'elle est inférieure au signal de référence de courant.

Fig. 1

1
2
4
5
6
9
3
7
8K
8H
8
8A
input current
10
13
input current detector
14
15
error amplifying circuit
drive circuit
11
reference signal
12
timer
16

Fig. 2
25
output voltage
26
27
23
28
output voltage detector
30
Vout
32
33
power controller
22
24
29
31
input current detector
Iin
input current
20
+
−
21
power source

Fig. 3
21
power source
20
24
23
27
26
output voltage
VOUT
25
22
input current Iin
29
input current detector
28
output voltage detector
31
ON OFF ON OFF
32'
33
45
46
48
49
error amplifying circuit
comparat.
30
50
51
saw tooth wave generating circuit
47

*Fig. 4*

input current
Iin (A)
output voltage
VOUT (Kvo-p)
magnetron being
not oscillated
magnetron
oscillating
12
7
4
2
0
0
A
B
input current Iin
output voltage VOUT
0
1
2
3
4
5
t(sec)

*Fig. 5*

33
input current
information
31
output voltage
information
30
45
46
error
amplifying
circuit
to
comparator 49
Vcc
47a
47

Fig. 6
input current information
output voltage information
31
30
diode circuit
45
reference signal generating circuit
47
error amplifying circuit
46
33
52
saw tooth wave generating circuit
50
comparator
49
to semiconductor switch 22

*Fig. 7*

Fig. 7
to semiconductor switch 22
comparator
49
saw tooth wave generating circuit
50
52
33
first error amplifying circuit
46
54
45
diode circuit
reference signal generating circuit
47
53
31
input current information
output voltage information
30
reference signal generating circuit

Fig. 8
input current Iin [A]
12
2
0
output voltage VOUT [KVO-P]
7
6
4
0
magnetron 25 being not oscillated
magnetron 25 being oscillated
input current Iin
output voltage VOUT
t [sec]
1
2
3
4
5

Fig. 9
power source
input current
Iin
input current detector
output voltage
VOUT
output voltage detector
ON OFF ON OFF
second error amplifying circuit
first error amplifying circuit
Vcc
comparator
saw tooth wave generating circuit
output voltage information
20
21
22
23
24
25
26
27
28
29
30
31
32"
33
55
56
57
58
59
60
61
62
63
64

Fig. 10
21
power source
+
20
−
input current Iin
24
22
23
27
26
output voltage VOUT
25
28
output voltage detector
29
input current detector
31
input current information
ON OFF ON OFF
32'''
68
error amplifying circuit
65
comparator
69
67
66R1
66c
66
66R2
saw tooth wave generating circuit
70
71
saw tooth wave
30
output voltage information
33
72s
72
comparator
73

input current Iin (A)
output voltage VOUT (KVO-P)
12
2
0
7
4
0
magnetron 25 oscillating
magnetron 25 being not oscillated
input current
output voltage
0
1
2
3
4
5
t (sec)

Fig. 11

Fig. 12
21
power source
+
20
−
input current
Iin
24
23
22
27
26
25
VOUT
output voltage
drive pulse
32
29
input current detector
28
output voltage detector
input current information
31
A D
A D
input ports
CPU
output port
driver
ROM RAM
output voltage information
30
75
software processor

*Fig. 13*

electric power ON
76
initial set
79
77
drive pulse output
output voltage information
input current information
input
78
data forming for setting
ON time.

Fig. 14
electric power ON
RAM
RAM (ON data)
RAM (output voltage information)
RAM (input current information)
90
96
97
constant
certain value (A)
certain value (B)
certain value (C)
88
98
99
RAM (ON data) initial set
80
timer (ON) start
81
drive pulse (ON) output
82
RAM (output voltage information) ← output voltage information
83
RAM (input current information) ← input current information
84
RAM (output voltage information) > RAM (input current information) ?
85
Yes
No
RAM (output voltage information) > certain value (A) ?
86
RAM (input current information) > certain value (A) ?
87
RAM (ON data) ← RAM (ON data) − certain value (B)
89
RAM (ON data) ← RAM (ON data) + certain value (C)
91
timer (ON) count up
92
drive pulse (OFF) output
93
timer (OFF) start
94
timer (OFF) count up ?
95

Fig. 15
RAM
RAM (ON data)
90
RAM (ON data V)
104
RAM (ON data I)
111
RAM (input current information
97
RAM (output voltage information
96
constant
certain value (D)
102
certain value (E)
114
certain value (F)
115
certain value (G)
113
certain value (H)
116
certain value (I)
117
electric power ON
RAM (ON data)
RAM (ON data V)
RAM (ON data I)
initial set
100
timer (OFF) start
81
drive pulse (ON) output
82
RAM (output voltage information) ← output voltage information
83
RAM (output voltage information) 〉 certain value (D) ?
101
Yes
No
103
RAM (ON data V) ← RAM (ON data V) certain value (E)
105
RAM (ON data V) ← RAM (ON data V) eertain value (F)
RAM (input current information) input current information
84
RAM (input current information 〉 certain value (G) ?
106
Yes
No
107
RAM (ON data I) ← RAM (ON data I) certain value (H)
108
RAM (ON data I) ← RAM (ON data I) certain value (I)
RAM (ON data V) 〉 RAM (ON data I) ?
109
Yes
No
112
RAM (ON data) RAM (ON data I)
110
RAM (ON data) RAM (ON data V)
95
timer (OFF) count up ?
Yes
No
94
timer (OFF) start
93
drive pulse (OFF) output
92
timer (ON) count up ?
Yes
No

Fig. 16
RAM
RAM (ON data)
90
RAM (current reference)
122
RAM (output voltage information)
96
RAM (input current information)
97
constant
certain value (J)
120
certain value (K)
129
certain value (L)
130
certain value (M)
125
certain value (N)
131
certain value (O)
132
electric power ON
RAM (ON data)
RAM (current reference)
initial set
118
timer (ON) start
81
drive pulse (ON) output
82
RAM (output voltage information)
output voltage information
83
119
RAM (output voltage information) > certain value (J) ?
Yes
No
121
RAM (current reference) ←
RAM (current reference)
-certain value (K)
123
RAM(current reference) ←
RAM(current reference)
+certain value (L)
124
certain value (M)
limit
84
RAM (input current information)
(input current information
126
RAM (input current information) > RAM(current reference) ?
Yes
No
127
RAM (ON data) ←
RAM (ON data)
certain value (N)
128
RAM (ON data) ←
RAM (ON data)
certain value (O)
95
timer (OFF) count up ?
Yes
No
94
timer (OFF) start
93
drive pulse (OFF) output
92
timer (ON) count up ?
Yes
No